# EUROPEAN PATENT APPLICATION

(11) **EP 2 072 990 A2**
(43) Date of publication of application: **24.06.2009**
(21) Application number: 08171311.7
(22) Date of filing: 11.12.2008
(51) Int. Cl.: G01M 3/38

(54) **Gas imaging system**

(30) Priority: 20.12.2007 US 962010
(71) Applicant: Daylight Solutions, Inc., Poway, CA 92064 (US)
(72) Inventor: Weida, Miles J., Poway CA 92064 (US); Day, Timothy, Poway, CA 92064 (US); Takeuchi, Eric, San Diego, CA 92128 (US)
(74) Representative: Viering, Jentschura & Partner

(57) **Abstract**

An imaging system (10) for imaging an emitting gas (12) includes an imager (16) and a laser source (20). The imager (16) captures an image (18) of light in the mid-infrared (MIR) range. The laser source (20) includes a semiconductor laser (334) that directly emits an output beam (26) that is in the MIR range. The output beam (26) may be adapted to backscatter near and/or be absorbed by the emitting gas (12). Thus, when an emitting gas (12) is present, the gas (12) may absorb and attenuate the backscattered light. As a result thereof, a shadow or contrast (18A) corresponding to the emitting gas (12) may be visible in the image (18) that is captured by the imager (16).

## Description

### BACKGROUND OF THE INVENTION

The present invention relates generally to imaging systems and, more particularly to imaging of gas emissions.

The usage, transportation, and storage of hazardous materials create many safety and environmental issues. More specifically, during usage, transportation, and storage of hazardous materials, leaks can release toxic or explosive gas into the surrounding environment. For example, industrial equipment used in the oil, gas, utility, and chemical industries can release toxic gas into the surrounding environment. As another example, hazardous gases can pose a threat to homeland security. In many cases, the hazardous gas is odorless, colorless, and spreads quickly. As a result thereof, it can be quite difficult to detect and locate the source of the leak.

In one specific example, sulfur hexafluoride ("SF6") is commonly used as an insulator for high voltage electrical equipment. SF6 is an inert gas that is relatively expensive and is a greenhouse gas having an estimated atmospheric lifetime of 3200 years. In this example, the SF6 is often contained in a chamber that surrounds at least a portion of the electrical equipment. A pressure gauge can be used to monitor the pressure of the SF6 in chamber. When the pressure in the chamber decreases, this is an indication that there is a SF6 leak. However, the exact location of the leak is still unknown.

One common way to locate the leak is to pour a soapy liquid over the chamber. Bubbles will appear at the location of the leak. Unfortunately, the chamber can be relatively large. Thus, it can take a significant amount of time to locate the leak. Further, because the electrical equipment is at a high voltage, it can be quite dangerous to use a soapy liquid on the electrical equipment.

Another method for locating a leaking gas uses a hand-held thermal imaging system to capture a thermal image of the area. In this method, if there is a temperature difference between the leaking gas and the rest of the environment, the leaking gas may be visible in thermal image. However, this method is not very effective if there is only a slight or no difference in temperature between the leaking gas and the rest of the environment.

### SUMMARY OF THE INVENTION

Embodiments of the present invention are directed to imaging systems for capturing an image of an emitting gas. In one embodiment, the imaging system includes an imager and a laser source. The imager captures an image of light in the mid-infrared (MIR) range. The laser source includes a semiconductor laser that directly emits (without frequency conversion) an output beam that is in the MIR range. In this embodiment, the output beam is directed at the emitting gas and is adapted to backscatter near and/or be absorbed by the emitting gas. For example, the output beam can backscatter from the emitting gas and/or the output beam can backscatter from an object positioned behind the target gas. With this design, when a target emitting gas is present, the gas absorbs and attenuates the backscattered light. As a result thereof, a shadow or contrast that corresponds to the emitting gas is clearly visible in the image that is captured by the MIR imager. In certain embodiments, because of the unique design disclosed herein, the gas imaging system is very accurate and can be extremely lightweight, stable, rugged, small, self-contained, and portable.

The imaging system can be useful for locating leaks in the oil, gas, and utility, chemical industries, as well as locating emitting gas for homeland security.

As used herein, to be classified as a MIR laser source, the output beam of the MIR laser source has a wavelength in the range of approximately 2-20 microns. Stated in another fashion, as used herein, the MIR range is approximately 2-20 microns. These MIR laser sources are particularly useful in absorption spectroscopy applications since many gases of interest have their fundamental vibrational modes in the MIR range and thus present strong, unique absorption signatures within the MIR range.

In one embodiment, the MIR laser source includes a mounting base, a QC gain media that is fixedly secured to the mounting base, a cavity optical assembly that is fixedly secured to the mounting base spaced apart from the QC gain media, and a wavelength dependent (WD) reflector that is secured to the mounting base spaced apart from the QC gain media. In this embodiment, the WD reflector cooperates with the QC gain media to form an external cavity that lases within the MIR range.

Additionally, the imaging system includes a battery that powers the MIR imager and/or the MIR laser source. With this design, the imaging system is very portable.

Further, the imaging system can include a temperature controller that is in thermal communication with the mounting base. In this embodiment, the temperature controller controls the temperature of the mounting base and the QC gain media. As a result of the integrated temperature controller, the imaging system can be used in remote locations away from external cooling sources. In certain embodiments, the temperature controller is required to ensure a constant optical output power for consistent operation. In these embodiments, the internal temperature control allows for consistent operation in remote locations. In an alternative embodiment, the imaging system can be operated without active temperature control.

In one embodiment, the wavelength of the output beam is selectively adjustable to any specific wavelength within the MIR range. With this design, the imaging system can be specifically set up to detect any specific gas of interest that has strong absorption in the MIR range.

In another embodiment, the MIR laser source generates output beams having different center wavelengths that are within the MIR range. With this design, the imaging system can scan for any gas having strong absorption in the MIR range.

Embodiments of the present invention are also directed to methods for detecting an emitting gas.

### BRIEF DESCRIPTION OF THE DRAWINGS

Figure 1 is simplified side illustration of a gas source, emitting gas, and a gas imaging system in accordance with embodiments of the present invention;

Figure 2 is simplified side illustration of the gas source, the emitting gas, and another embodiment of a gas imaging system in accordance with embodiments of the present invention;

Figure 3 is simplified side illustration, in partial cut-away of a MIR laser source in accordance with embodiments of the present invention;

Figure 4 is simplified side illustration, in partial cut-away of another embodiment of a MIR laser source in accordance with embodiments of the present invention;

Figures 5A-5E are alternative illustrations of a WD feedback assembly in accordance with embodiments of the present invention;

Figure 6A is a simplified graph that illustrates absorption versus wavelength for an emitting gas;

Figure 6B is a simplified graph that illustrates the output versus wavelength for an output beam;

Figure 7A is a simplified graph that illustrates absorption versus wavelength for two emitting gases;

Figure 7B is a simplified graph that illustrates the output versus wavelength for another output beam;

Figure 8A is a simplified graph that illustrates absorption versus wavelength for three emitting gases;

Figure 8B is a simplified graph that illustrates the output versus wavelength for a plurality of output beams;

Figure 9A is a simplified illustration of a display in accordance with embodiments of the present invention;

Figure 9B is a simplified illustration of another display in accordance with embodiments of the present invention;

Figure 10 is simplified side illustration of the gas source, the emitting gas, and yet another embodiment of a gas imaging system in accordance with embodiments of the present invention; and

Figure 11 is a graph that illustrates power directed to a QC gain media versus time.

### DETAILED DESCRIPTION OF CERTAIN EMBODIMENTS

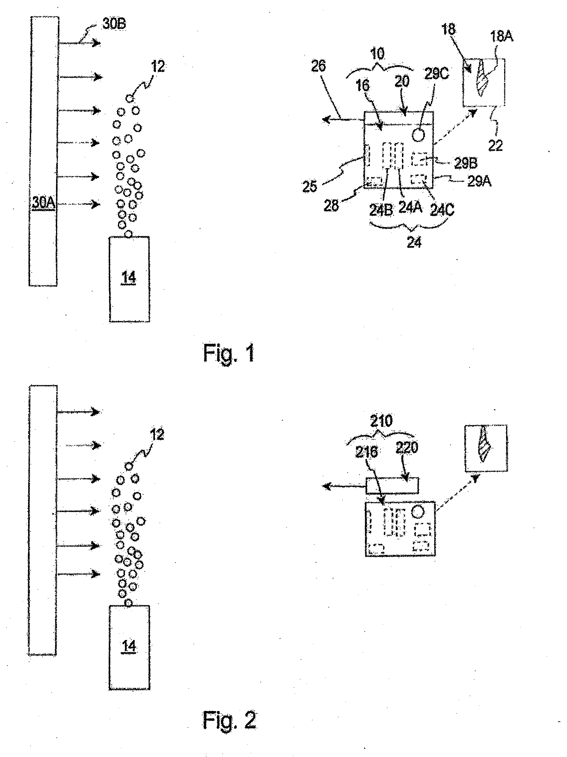

Figure 1 illustrates a simplified side illustration of a gas imaging system 10 that is suited for imaging, locating, detecting, and/or identifying an emitting gas 12 that is emitting from a gas source 14. In one embodiment, the gas imaging system 10 includes a mid-infrared (MIR) imager 16 that provides an image 18 of the emitting gas 12, and an MIR laser source 20 that illuminate the area near the emitting gas 12 and significantly improves the image 18 captured by the MIR imager 16. As a result thereof, the gas imaging system 10 can be used to quickly and accurately locate and/or identify the emitting gas 12 even if there is little or no temperature difference between the emitting gas 12 and the surrounding environment.

Further, in certain embodiments, because of the unique design disclosed herein, the gas imaging system 10 can be extremely compact, hand-held, lightweight, stable, rugged, small, self-contained, and portable. For example, the imaging system 10 can have dimensions of approximately 130 millimeters (height) by 145 millimeters (width) by 250 millimeters (length) (where length is taken along the propagation direction of the laser beam) or less.

A number of Figures include an orientation system that illustrates an X axis, a Y axis that is orthogonal to the X axis and a Z axis that is orthogonal to the X and Y axes. It should be noted that these axes can also be referred to as the first, second and third axes.

The type of emitting gas 12 detectable by the gas imaging system 10 can include any gas having molecules that absorb ("absorption features") in the MIR range. A non-exclusive example of gases 12 having absorption features in the MIR range that can be detected includes, but is not limited to, (i) sulfur hexafluoride (SF6), (ii) Acetylchloride, (iii) Ethylene, (iv) Freon (such as dichlorodifluoromethane), (v) Propenal, (vii) Tricholorethylene, (viii) methane (CH4), (ix) ethylene (C2H4), (x) ethane (C2H6), (xi) hydrogen chloride (HCl), (xii) ammonia (NH3), (xiii) nitrous oxide (NO), (xiv) hydrazine (N2H4), and (xv) monomethyl hydrazine (MMH). Yet another example of gases 12 includes (i) chemical agents such as mustard gas or other gases that may pose problems for the military, and/or (ii) chlorine, hydrogen peroxide, or other gases that may pose problems for homeland security.

A non-exclusive list of possible gas sources 14 includes containers, power plants, industrial equipment, gas lines, storage tanks, and electrical equipment.

The MIR imager 16 captures the image 18 of the emitting gas 12. In one embodiment, the MIR imager 16 is an infrared camera that provides real-time, high resolution thermal images 18 of the emitting gas 12 that can be displayed on a display 22 or recorded for future viewing. In Figure 1, for convenience, the display 22 is illustrated as being positioned away from the MIR imager 16. However, the display 22 can be a screen that is attached to the MIR imager 16.

In one embodiment, the MIR imager 16 includes a capturing system 24 (illustrated as a box in phantom) that captures information for the scene in front of the MIR imager 16; a lens assembly 25 that focuses light on the capturing system 24; and an imager control system 28. The design of the capturing system 24 can vary. For example, the capturing system 24 can include an image sensor 24A (illustrated in phantom), a filter assembly 24B (illustrated in phantom), and a storage system 24C (illustrated in phantom).

The image sensor 24A receives the light that passes through the filter assembly 24B and converts the light into electricity. Examples of suitable image sensors 24A can include microbolmeters, quantum well infrared photodetectors, or thermal light valve technology sold by Redshift Systems Corporation, located in Burlington, MA.

The filter assembly 24B limits the wavelength of the light that is directed at the image sensor 24A. For example, if the imaging system 10 is designed to detect any gas that absorbs in the MIR range, the filter assembly 24B can be designed to transmit all light in the MIR range, and block all light having a wavelength that is greater or lesser than the MIR range. Alternatively, if the imaging system 10 is designed to detect a single gas having significant absorption at a particular wavelength in the MIR range, the filter assembly 24B can be designed to transmit light at that particular wavelength in the MIR range, and block all light having a wavelength that is greater or lesser than the particular wavelength. With this design, the image sensor 24A responds primarily to desired wavelength, and ignores other background thermal emissions.

The storage system 24C stores the various images. Non-exclusive examples of suitable storage systems 24C include flash memory, a floppy disk, a hard disk, or a writeable CD or DVD.

The imager control system 28 is electrically connected to and controls the operation of the electrical components of the MIR imager 16. The imager control system 28 can include one or more processors and circuits and the control system 28 can be programmed to perform one or more of the functions described herein. The imager control system 28 receives information from the image sensor 24A and generates the image 18. Additionally, or alternatively, the image control system 28 can further enhance the image 18 with color or other features that will further identify the location or type of emitting gas 12. In certain embodiments, the imager control system 28 can analyze the information from one or more images 18 to identify the one or more specific emitting gases 12 that are present and/or determine the quantity of one or more emitting gases 12 that are present.

In one embodiment, the imager control system 28 controls the components of just the MIR imager 16. Alternatively, the imager control system 28 can control both the MIR imager 16 and the MIR laser source 20.

In Figure 1, the MIR Imager 16 and the MIR laser source 20 share a common housing 29A. Alternatively, as described below, the MIR Imager 16 and the MIR laser source 20 can have separate housings.

Additionally, the MIR imager 16 can include a battery 29B (illustrated in phantom) for powering the MIR imager 16. This allows for the portable operation of the MIR imager 16 in remote locations. Alternatively, for example, the MIR Imager 16 and the MIR laser source 20 can share a common battery, or the imaging system 10 can be connected with an electrical cord to a power outlet.

The MIR laser source 20 generates an output beam 26 in the MIR range. The design of the MIR laser source 20 can be varied to achieve the desired type of gas detection. In one embodiment, the MIR laser source 20 generates an output beam 26 that is fixed at a precisely selected specific wavelength in the MIR range. Alternatively, the laser source 20 can generate an output beam 26 that is selectively adjustable to any specific wavelength in the MIR range. Still alternatively, the MIR laser source 20 can be designed to generate a set of sequential, specific output beams 26 that span a portion or the entire the MIR range.

With these designs, as detailed below, the wavelength of the output beam 26 or the set of output beams from the MIR laser source 20 can be specifically tailored to target the absorption features of the gas 12 or gases 12 of interest. This enhances the accuracy of the imaging system 10. For example, in one embodiment, the output beam 26 is adjusted to a first specific wavelength for detecting one type of gas, and subsequently is adjusted to a second specific wavelength for detecting a second type of gas. The wavelength of the output beam 26 can be manually or automatically switched between the different wavelengths.

In the embodiments provided herein, the MIR laser source 20 is a semiconductor type laser that directly emits the output beam 26 that is within MIR range without any frequency conversion. Suitable MIR laser sources 20 are described in more detail below.

As illustrated in Figure 1, the output beam 26 is directed at a background 30A near a possible site of a gas leakage. The MIR Imager 16 captures both backscattered light 30B (illustrated as arrows) that is reflected off of the background 30B and background radiation. When a detectable emitting gas 12 is present, the backscattered light 30B is highly attenuated. This produces a region of contrast or shadow 18A on the image 18 that corresponds to and clearly illustrates the emitting gas 12. The background 30A can be any object that reflects the output beam 28.

Moreover, the imaging system 10 can include one or more switches 29C that can be used to control the operation of the MIR imager 16 and/or the MIR laser source 20.

Figure 2 illustrates a simplified side illustration of another embodiment of a gas imaging system 210 that is suited for imaging, locating, identifying, and/or detecting an emitting gas 12 from a gas source 14. In this embodiment, the imaging system 210 includes a MIR imager 216 and a MIR laser source 220 that are similar to the corresponding components described above and illustrated in Figure 1. However, in this embodiment, the MIR imager 216 and the MIR laser source 220 are separate from each other and can be moved relative to each other.

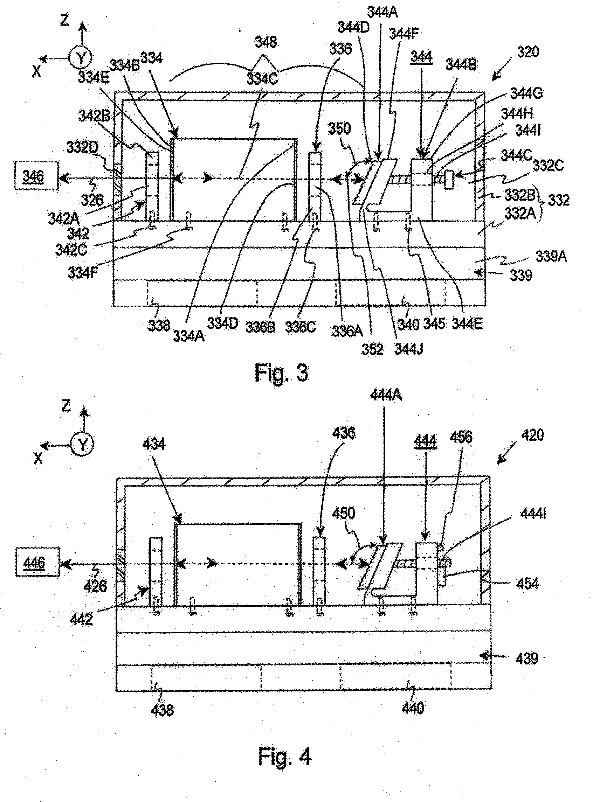

Figure 3 illustrates a first embodiment of a MIR laser source 320 in accordance with embodiments of the present invention that can be used in the imaging systems 10, 210, 1010 illustrated in Figures 1, 2 and 10. In this embodiment, the MIR laser source 320 includes a source frame 332, a quantum cascade ("QC") gain media 334, a cavity optical assembly 336, a power source 338 (illustrated in phantom), a temperature controller 339, a laser electronic controller 340 (illustrated in phantom), an output optical assembly 342, and a wavelength dependant ("WD") feedback assembly 344 that cooperate to generate a selectable, fixed, output beam 326 that is in the MIR range. The design of each of these components can be varied pursuant to the teachings provided herein. In should be noted that the MIR laser source 320 can be designed with more or fewer components than described above. For example, if the MIR laser source 320 is integrated into the same housing 29 with the MIR imager 16 as illustrated in Figure 1, these devices can share the same frame 332, electronic controller 340, power source 338, and/or temperature controller 339.

As an overview of this MIR laser source 320, in certain embodiments, the WD feedback assembly 344 includes a wavelength dependent (WD) reflector 344A that cooperates with the QC gain media 334 to form an external cavity 348. Further, the WD reflector 344A can be tuned to adjust the lasing frequency of the external cavity 348 and the wavelength of the output beam 326, and the relative position of the WD feedback assembly 344 and QC gain media 334 can be fixedly maintained so that the laser source 320 produces a precise, fixed wavelength MIR output beam 326. Stated in another fashion, the feedback assembly 344 can be tuned (without changing the QC gain media 334) to achieve the desired wavelength of the output beam 326 within the MIR range. This results in a high production yield, and ultimately a relatively inexpensive to make MIR laser source 320.

In alternative, non-exclusive embodiments, the WD reflector 344A can be used to control the fixed center wavelength of output beam 326 within the MIR range to within approximately 0.1, 0.01, 0.001, or 0.0001 microns. As a non-exclusive example, the WD reflector 344A can be adjusted so that the MIR laser source 320 has a fixed output beam 326 of (i) 9.125 microns, (ii) 9.126 microns, (iii) 9.127 microns, (iv) 9.128 microns, (v) 9.129 microns, (vi) 9.130 microns, or any other specific wavelength in the MIR range. With this design, the MIR laser source 320 can be tuned so the output beam 326 is at a precisely selected specific wavelength in the MIR range that is best suited for identifying the desired particular emitting gas.

In certain embodiments, with the designs provided herein, the output beam 326 has a relatively narrow line width. In non-exclusive examples, the MIR laser source 320 can be designed so that the line width of the output beam 326 is less than approximately 5, 4, 3, 2, 1, 0.8, 0.5, or 0.1 cm-1. Alternatively, the MIR laser source 320 can be designed so that the line width of the output beam 326 is greater than approximately 7, 8, 9, or 10 cm-1. The spectral width of the output beam 326 can be adjusted by adjusting the cavity parameters of the external cavity. For example, the spectral width of the output beam 326 can be increased by increasing the focal length of the cavity optical assembly 336.

The source frame 332 supports at least some of the components of the laser source 320. In one embodiment, (i) the QC gain media 334, the cavity optical assembly 336, the output optical assembly 342, and the WD feedback assembly 344 are each fixedly secured, in a rigid arrangement to the source frame 332; and (ii) the source frame 332 maintains these components in precise mechanical alignment to achieve the desired wavelength of the output beam 326.

Additionally, in Figure 3, the power source 338, the temperature controller 339, and the laser electronic controller 340 are fixedly secured to the source frame 332. With this design, all of the critical components are fixed to the source frame 332 in a stable manner, and the laser source 320 can be self-contained and extremely portable. Alternatively, for example, the power source 338, the temperature controller 339, and/or the laser electronic controller 340 can be separate from and external to the source frame 332.

The design of the source frame 332 can be varied to achieve the design requirements of the laser source 320. In Figure 3, the source frame 332 includes a mounting base 332A, and a cover 332B. Alternatively, for example, the source frame 332 can be designed without the cover 332B and/or can have a configuration different from that illustrated in Figure 3.

The mounting base 332A provides a rigid platform for fixedly mounting the QC gain media 334, the cavity optical assembly 336, the output optical assembly 342 and the WD feedback assembly 344. In Figure 3, the mounting base 332A is illustrated as being generally rectangular plate shaped. In one embodiment, the mounting base 332A is a monolithic structure that provides structural integrity to the MIR laser source 320. Alternatively, the mounting base 332 can have a configuration that is different than that illustrated in Figure 3.

In certain embodiments, the mounting base 332A is made of rigid material that has a relatively high thermal conductivity. In one non-exclusive embodiment, the mounting base 332A has a thermal conductivity of at least approximately 170 watts/meter K. With this design, in addition to rigidly supporting the components of the MIR laser source 320, the mounting base 332A also readily transfers heat away from the QC gain media 334 to the temperature controller 339. For example, the mounting base 332A can be fabricated from a single, integral piece of copper, copper-tungsten or other material having a sufficiently high thermal conductivity. The one piece structure of the mounting base 332A maintains the fixed relationship of the components mounted thereto and contributes to the small size and portability of the MIR laser source 320.

The cover 332B is secured to the mounting base 332A, and the cover 332B cooperates with the mounting base 332A to define a cover cavity 332C and form a housing that encloses and protects the QC gain media 334, the cavity optical assembly 336, the output optical assembly 342 and the WD feedback assembly 344. In Figure 3, the cover 332B is shaped somewhat similar to an inverted, open rectangular box. Additionally, the cover 332B can include a transparent window 332D that allows the output beam 326 to pass through the cover 332B.

Additionally, the cover 332B can include a cover fastener (not shown) that secures the cover 332B to the mounting base 332A. For example, the cover fastener can include one or more threaded bolts, an adhesive, one or more clamps, solder, or a weld.

In one embodiment, the cover 332B is hermetically sealed to the mounting base 332A in an air tight manner. This allows the source frame 332 to provide a controlled environment around some of the components of the laser source 320. For example, the cover cavity 332C can be filled with a fluid such as nitrogen or an air/nitrogen mixture to keep out moisture and humidity; or the cover cavity 332C can be subjected to a vacuum.

In certain embodiments, the overall size of the source frame 332 is quite small so that the laser source 320 is very portability. For example, the source frame 332 can have dimensions of approximately 20 centimeter (height) by 20 centimeters (width) by 20 centimeters (length) (where length is taken along the propagation direction of the laser beam) or less, and more preferably, the source frame 332 has dimensions of approximately 3 centimeters (height) by 4 centimeters (width) by 5 centimeters (length). Still alternatively, the source frame 332 can have dimensions of less than approximately 10 millimeters (height) by 25 millimeters (width) by 30 millimeters.

The QC gain media 334 is a unipolar semiconductor laser that includes a series of energy steps built into the material matrix while the crystal is being grown. With this design, electrons transmitted through the QC gain media 334 emit one photon at each of the energy steps. In one embodiment, the QC gain media 334 uses two different semiconductor materials such as InGaAs and AlInAs (grown on an InP or GaSb substrate for example) to form a series of potential wells and barriers for electron transitions. The thickness of these wells/barriers determines the wavelength characteristic of the QC gain media 334. Fabricating QC gain media of different thickness enables production of MIR laser having different output frequencies within the MIR range.

It should be noted that fine tuning of the output beam 326 may be achieved by controlling the temperature of the QC gain media 334, such as by changing the DC bias current. Such temperature tuning is relatively narrow and may be used to vary the wavelength by approximately 1-2 gigahertz/Kelvin which is typically less than 0.01 % of the peak emission wavelength.

In the case of QC gain media 334, the "diode" has been replaced by a conduction band quantum well. Electrons are injected into the upper quantum well state and collected from the lower state using a superlattice structure. The upper and lower states are both within the conduction band. Replacing the diode with a single-carrier quantum well system means that the generated photon energy is no longer tied to the material bandgap. This removes the requirement for exotic new materials for each wavelength, and also removes Auger recombination as a problem issue in the active region. The superlattice and quantum well can be designed to provide lasing at almost any photon energy that is sufficiently below the conduction band quantum well barrier.

As used herein the term QC gain media 334 shall also include Interband Cascade Lasers (ICL) in addition to Quantum Cascade type media. ICL lasers use a conduction-band to valence-band transition as in the traditional diode laser.

Additionally, as used herein, the term semiconductor shall include, without limitation, any solid crystalline substance having electrical conductivity greater than insulators but less than good conductors. Generally, a semiconductor material includes any material having an electrical charge carrier concentration that increases with temperature over some temperature range and having a resistivity in its normal operating temperature range of, for example, between 10E(-4) and 1 0E11 ohm-centimeters.

In Figure 1, the QC gain media 334 includes (i) a first facet 334A that faces the cavity optical assembly 336 and the WD feedback assembly 344, and (ii) a second facet 334B that faces the output optical assembly 342, In this embodiment, the QC gain media 334 emits from both facets 334A, 334B.

In one embodiment, the first facet 334A is coated with an anti-reflection ("AR") coating 334D and the second facet 334B is coated with a reflective coating 334E. The AR coating 334D allows light directed from the QC gain media 334 at the first facet 334A to easily exit the QC gain media 334 and allows the light reflected from the WD feedback assembly 344 to easily enter the QC gain media 334. In contrast, the reflective coating 334E reflects at least some of the light that is directed at the second facet 334B from the QC gain media 334 back into the QC gain medium 334. In one non-exclusive embodiment, the AR coating 334D can have a reflectivity of less than approximately 2 percent, and the reflective coating 334E can have a reflectivity of between approximately 2-95 percent. In this embodiment, the reflective coating 14E acts as an output coupler for the external cavity 348.

In one embodiment, the QC gain media 334 is approximately 2 millimeters by 0.5 millimeters, by 90 microns. Further, the QC gain media 334 can include a media fastener 334F that fixedly secures the QC gain media 334 to the mounting base 332A. For example, the media fastener 334F can include one or more threaded bolts, an adhesive, one or more clamps, solder, or a weld.

A suitable QC gain media 334 can be purchased from Alpes Lasers, located in Switzerland.

The QC gain media 334 generates a relatively strong output IR beam and also generates quite a bit of heat if operated continuously. Accordingly, the temperature controller 339 can be an important component that is needed to remove the heat, thereby permitting long lived operation of the laser source 320 and consistent optical output power.

The cavity optical assembly 336 is positioned between the QC gain media 334 and the WD feedback assembly 344 along a lasing axis 334C (along the X axis in Figures), and collimates and focuses the light that passes between these components. For example, the cavity optical assembly 336 can include one or more lens 336A (one is illustrated in phantom), a lens mount 336B and a lens fastener 336C.

For example, the lens 336A can be an aspherical lens having an optical axis that is aligned with the lasing axis 334C. In one embodiment, to achieve the desired small size and portability, the lens 336A has a relatively small diameter. In alternative, non-exclusive embodiments, the lens 336A has a diameter of less than approximately 5 or 10 millimeters, and a focal length of approximately 1, 2, 3, 4, 5, 6, 7, 8, 9, 10, 11, 12, 13, 14, 15, 16, 17, 18, 19, or 20 mm and any fractional values thereof. The lens 336A can comprise materials selected from the group of Ge, ZnSe, ZnS Si, CaF, BaF or chalcogenide glass. However, other materials may also be utilized. The lens 336A may be made using a diamond turning or molding technique. The lens 336A can be designed to have a relatively large numerical aperture (NA). For example, the lens 336A can have a numerical aperture of at least approximately 0.6, 0.7, or 0.8. The NA may be approximated by the lens diameter divided by twice the focal length. Thus, for example, a lens diameter of 5 mm having a NA of 0.8 would have a focal length of approximately 3.1 mm.

The lens mount 336B fixedly and rigidly retains the lens 336A. For example, the lens mount 336B can be a rigid bracket. The lens fastener 336C fixedly and rigidly secures the lens mount 336B and the lens 336A to the mounting base 332A. For example, the lens fastener 336C can include one or more threaded bolts, an adhesive, one or more clamps, solder, or a weld.

The power source 338 provides electrical power for the QC gain media 334, the laser electronic controller 340, and the temperature controller 339. In Figure 3, the power source 338 is a battery that is secured to the source frame 332. For example, the battery can be nickel metal hydrate. Alternatively, the power source 338 can be external to the source frame 332. For example, the power source 338 can be an external battery or a power outlet.

The temperature controller 339 can be used to control the temperature of the QC gain media 334, the mounting base 332A, and/or one or more of the other components of the laser source 320. Further, the temperature controller 339 can be used to maintain the relative position of the QC gain media 334, the optical assemblies 336, 342 and the WD feedback assembly 344.

In one embodiment, the temperature controller 339 includes a thermoelectric cooler 339A and a temperature sensor (not shown). The thermoelectric cooler 339A may be controlled to effect cooling or heating depending on the polarity of the drive current thereto. In Figure 3, the thermoelectric cooler 339A is fixed to the bottom of the mounting base 332A so that the thermoelectric cooler 339A is in direct thermal communication with the mounting base 332A, and so that the thermoelectric cooler 339A can provide additional rigidity and support to the mounting base 332A. In one embodiment, the top of the thermoelectric cooler 339A is approximately the same size as the bottom surface of the mounting base 332A. This promotes good heat transfer between the thermoelectric cooler 339A and the mounting base 332A, and maximizes the support for the mounting base 332A provided by the thermoelectric cooler 339A. The thermoelectric cooler 339A can be fixedly secured to the mounting base 332A with bolts, epoxy, welding, solder or other suitable means.

Alternatively, an intermediate plate may be attached between the thermoelectric cooler 339A and the mounting base 332A.

In certain embodiments, the temperature controller 339 can be used to change the temperature of the laser source 320 to affect a relatively small wavelength tuning range on the order 0.01 % or less.

The temperature sensor provides temperature information that can be used to control the operation of the thermoelectric cooler 339A so that the thermoelectric cooler 339A can maintain the desired temperature of the MIR laser source 320. The temperature sensor may comprise an encapsulated integrated circuit with a thermistor as the temperature sensor active component. The temperature sensor can be positioned on the mounting base 332A near the QC gain media 334 and can be used to monitor the temperature of the QC gain media 334.

Additionally, or alternatively, the source frame 332 can be mounted to a heat sink (not shown) inside a larger housing (not shown) which may also contain additional equipment including cooling fans and vents to further remove the heat generated by the operation of the laser source 320.

The laser electronic controller 340 controls the operation of the MIR laser source 320 including the electrical power that is directed to the QC gain media 334 and the temperature controller 339. For example, the laser electronic controller 340 can include a processor that controls QC gain media 334 by controlling the electron injection current. In Figure 3, the laser electronic controller 340 is rigidly and fixedly mounted to the source frame 332 so that the laser source 320 is portable and rugged. Alternatively, for example, the laser electronic controller 340 can be external to the source frame 332.

In certain embodiments, in order to achieve good contrast in the captured image, is may be necessary to generate an output beam 326 having an average optical power of greater than approximately 50 milliwatts. Further, in certain embodiments, an even better contrast can be achieved with an output beam having an average optical power greater than approximately 1- 2 watts.

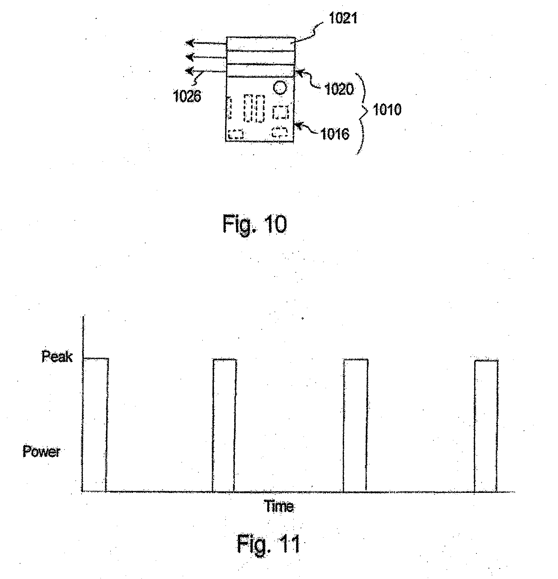

As provided herein, the laser electronic controller 340 can direct power to the QC gain media 334 in a fashion that minimizes heat generation in, and power consumption of the QC gain media 334 while still achieving the desired average optical power of the output beam 326. With this design, the QC gain media 334 operates efficiently because it is not operating at a high temperature, the need to actively cool the QC gain media 334 is reduced or eliminated, and the MIR laser source 20 can be powered with a relatively small battery. One example of how power can be directed to the QC gain media 334 is described in more detail below and illustrated in Figure 11.

The output optical assembly 342 is positioned between the QC gain media 334 and the window 332D in line with the lasing axis 334C; and the output optical assembly 342 collimates and focuses the light that exits the second facet 334B of the QC gain media 334. For example, the output optical assembly 342 can include one or more lens 342A (one is illustrated in phantom), a lens mount 342B and a lens fastener 342C.

The lens 342A can be somewhat similar in design to the lens 336A of the cavity optical assembly 336. The lens mount 342B fixedly and rigidly retains the lens 342A. For example, the lens mount 342B can be a rigid bracket. The lens fastener 342C fixedly and rigidly secures the lens mount 342B and the lens 342A to the mounting base 332A. For example, the lens fastener 342C can include one or more threaded bolts, an adhesive, one or more clamps, solder, or a weld.

The WD feedback assembly 344 reflects the light back to the QC gain media 334 along the lasing axis 334C, and is used to precisely adjust the lasing frequency of the external cavity 348 and the wavelength of the output beam 326. Stated in another fashion, the WD feedback assembly 344 is used to feed back to the QC gain media 334 a relatively narrow band wavelength which is then amplified in the QC gain media 334. In this manner, the output beam 326 may be tuned and set to a desired fixed wavelength with the WD feedback assembly 344 without adjusting the QC gain media 334. Thus, in the external cavity 348 arrangements disclosed herein, the WD feedback assembly 344 dictates what wavelength will experience the most gain and thus dominate the wavelength of the output beam 326.

As provided above, the WD feedback assembly 344 includes the WD reflector 344A that has wavelength dependent reflectivity. The design of the WD reflector 344A and the WD feedback assembly 344 can vary pursuant to the teachings provided herein. Non-exclusive examples of a suitable WD reflector 344A includes a diffraction grating, a MEMS grating, prism pairs, a thin film filter stack with a reflector, an acoustic optic modulator, or an electro-optic modulator. A more complete discussion of these types of WD reflectors 344A can be found in the Tunable Laser Handbook, Academic Press, Inc., Copyright 1995, chapter 8, Pages 349-435, Paul Zorabedian.

In Figure 3, the WD reflector 344A is spaced apart from the QC gain media 334 and cooperates with the QC gain media 334 to form the external cavity 348. In this embodiment, the external cavity 348 extends from the output coupler (reflective coating 334E) to the WD reflector 344A. The term external cavity 348 is utilized to designate the WD reflector 344A positioned outside of the QC gain media 334. In Figure 3, the external cavity 348 is not external to the source frame 332 in which the QC gain media a 334 is contained. Instead, in Figure 3, the external cavity 348 is contained within the source frame 332.

The type of adjustment done to the WD reflector 344A to adjust the lasing frequency of the external cavity 348 and the wavelength of the output beam 326 will vary according to the type of WD reflector 344A. For example, if the WD reflector 344A is a diffraction grating, rotation of the diffraction grating relative to the lasing axis 334C and the QC gain media 334 adjusts the lasing wavelength and the wavelength of the output beam 326. There are many different ways to precisely rotate and fix the position of the diffraction grating. Only a few, non-exclusive examples are illustrated and discussed in detail herein.

In Figure 3, the WD reflector 344A is a diffraction grating that includes a glass or polished metal reflector surface 344D having a large number of very fine parallel grooves or slits. With this design, rotation of the reflector surface 344D relative to the QC gain media 334 and the incident beam 352 changes the angle of incidence 350 of the beam 352 onto the reflector surface 344D and the wavelength of the light. Stated in another fashion, the reflector surface 344D is selectively movable relative to the QC gain media 334 to precisely adjust the lasing wavelength of the external cavity 348.

In this embodiment, changing the incidence angle 350 serves to preferentially select a single wavelength which is the first order diffracted light from the reflector surface 344D. This light is diffracted back onto the same path as the incident beam 352 to thereby tune the external cavity 348 to the diffracted wavelength. The diffracted laser light is received by the QC gain media 334 to provide stimulated laser emission thereby resonating the QC gain media 334 with the grating selected wavelength.

Additionally, as illustrated in Figure 3, the WD feedback assembly 344 includes a feedback fastener 345 that fixedly and rigidly secures the WD feedback assembly 344 to the mounting base 332A. For example, the feedback fastener 345 can include one or more threaded bolts, an adhesive, one or more clamps, solder, or a weld.

Moreover, in Figure 3, the WD feedback assembly 344 includes a reflector retainer 344B, and a reflector lock 344C. The reflector retainer 344B (i) retains the WD reflector 344A, (ii) allows for rotation of the reflector surface 344D relative to the incident beam 352, and the QC gain media 354, and (iii) secures the WD reflector 344A to the mounting base 332A. The design and attachment of the reflector retainer 344B can vary. Figure 3 illustrates one, non-exclusive embodiment of the reflector retainer 344B. In this embodiment, the reflector retainer 344B includes a retainer base 344E, a retainer plate 344F, and a fixed plate 344G that are arranged so that the reflector retainer 344B is shaped somewhat similar to a truncated right triangle.

In one embodiment, the retainer base 344E is generally rectangular plate shaped and is fixedly secured to the mounting base 332A with the feedback fastener 345. The retainer plate 344F directly retains the WD reflector 344A. In Figure 3, the retainer plate 344F is generally rectangular plate shaped and cantilevers upward from the retainer base 344E at an acute angle. Additionally, the intersection of the retainer plate 344F and the retainer base 344E functions as a flexural pivot 344J and can include a cut-out that allows the retainer plate 344F to pivot relative to the retainer base 344E. Moreover, in this embodiment, the fixed plate 344G is generally rectangular plate shaped and cantilevers upward from the retainer base 344E at approximately a right angle.

In one embodiment, the reflector retainer 344B is made of a single piece of material. Non-exclusive examples of suitable materials for the reflector retainer 344B include aluminum and copper. Alternatively, for example, the retainer plate 344F can be secured to the retainer base 344E with a hinge or another type of pivot that allows for pivoting of the retainer plate 344F relative to the rest of the reflector retainer 344B. In one embodiment, the retainer plate 344F is biased to pivot towards the fixed plate 344G.

The reflector lock 344C can be used to selectively move the retainer plate 344F and the WD reflector 344A relative to the other components of the laser source 320 and to selectively inhibit relative movement between the WD reflector 344A and the QC gain media 334. In Figure 3, the reflector lock 344C includes an internally threaded surface 344H (illustrated as dashed lines) in the fixed plate 344G and an externally threaded member 344I (e.g. a bolt) that threads into the internally threaded surface 344H. In this embodiment, the bolt 344I includes a distal end that engages the back of the retainer plate 344F, and proximal head that can be rotated by a user to pivot the WD reflector 344A. With this design, rotation of the bolt 344I in one direction causes the flexural pivot 344J to bend and the angle of incidence 350 to decrease, and rotation of the bolt 3441 in the opposite direction causes the flexural pivot 344J to bend and the angle of incidence 350 to increase. With this design, the user can finely tune the wavelength of the external cavity 348 separate from the QC gain media 334. In one non-exclusive embodiment, the bolt 3441 can be used to rotate the WD reflector 344A approximately five degrees to precisely adjust the wavelength of the output beam 326.

In this embodiment, during manufacturing of the laser source 320, the various components (except the cover 332B) can be fixedly attached to the mounting base 332A. Next, the laser source 320 can be turned on, and a wavelength measurement device 346 can be used to precisely measure the wavelength of the output beam 326. Subsequently, the bolt 3441 can be rotated until the laser source 320 generates the desired fixed wavelength output beam 326. Finally, the cover 332B can be secured to the mounting base 332A. Alternatively, the laser source 320 could be designed so that the WD reflector 344A can be rotated with the cover 332B secured to the mounting base 332A.

With this design, the MIR laser source 320 generates an output beam 26 that is fixed at a precisely selected specific wavelength in the MIR range. With this design, the wavelength of the output beam 326 can be specifically tailored to target the absorption features of the gas 12 or gases of interest. This enhances the accuracy of the imaging system 10.

It should be noted that the processes used to the manufacture the laser sources disclosed herein can be performed manually or in an automated assembly process. For example, the laser sources disclosed herein can be tuned with a robot, a human or a combination thereof.

It should also be noted that many other methods can be utilized to adjust the position of the WD reflector 344A and fix the position of the WD reflector 344A relative to the QC gain media 334 when the desired wavelength is achieved. For example, the reflector retainer 344B can be attached to the mounting base 332A with a pad of adhesive that allows for rotation of the reflector retainer 344B prior the setting of the adhesive. Still alternatively, the mounting base 332A can include a curved region and the position in which the reflector retainer 344B is secured to the curved region determines the angle of rotation of the WD reflector, the lasing wavelength of the external cavity 328, and the fixed wavelength of the output beam 326.

Figure 4 is a simplified illustration of another embodiment of the laser source 420 that includes a QC gain media 434, a cavity optical assembly 436, a power source 438, a temperature controller 439, a laser electronic controller 440, an output optical assembly 442 that are similar to the corresponding components described above. However, in this embodiment, the WD feedback assembly 444 is slightly different.

More specifically, in this embodiment, the WD feedback assembly 444 includes an electric actuator 454 that precisely rotates a WD reflector 444A (e.g. a diffraction grating) relative to the QC gain media 434 to precisely adjust the wavelength of the output beam 426. With this design, the laser electronic controller 440 can be used to precisely control the actuator 454 to precisely select the desired wavelength of the output beam 426 from the MIR range.

The type of actuator 454 and the attachment of the actuator 454 can vary greatly. Non-exclusive examples of suitable actuators 454 include a stepper motor, a piezoelectric actuator, or a voice coil motor.

In Figure 4, the actuator 454 is a motor that rotates the bolt 444I to adjust the angle of the WD reflector 444A and the angle of incidence 450 to adjust the wavelength of the output beam 426.

Additionally, in Figure 4, the laser source 420 can include a measurement system 456 that monitors the position of the WD reflector 444A, and/or the position of another portion of the WD feedback assembly 444. For example, the measurement system 456 can be an encoder or another type of sensor.

In this embodiment, the MIR laser source 420 can be controlled to generate an output beam 426 that is selectively adjustable to any specific wavelength in the MIR range. With this design, the wavelength of the output beam 426 can be specifically tailored to target the absorption features of the gas 12 or gases 12 of interest. Further, same imaging system 10, 210 can be controlled to detect any gas have strong absorption in the MIR range. Stated in another fashion, the tunability allows the same MIR laser source 420 to be used to illuminate many different gases. Further, the wavelength selectivity allows the MIR laser source 420 to be optimized to the most appropriate absorption feature for the gas to be imaged.

Further, in certain embodiments, the electronic controller 440 can control the actuator 454 to adjust the WD feedback assembly 444 to generate a set of sequential, specific, different wavelength output beams 426 that span a portion or the entire the MIR range. In one non-exclusive example, the MIR laser source 420 can be controlled to sequentially generate 20 different wavelength output beams 426 that cover a detection range of approximately 18 microns (e.g. 2 to 20 microns). In another non-exclusive example, the MIR laser source 420 can be controlled to sequentially generate 20 different wavelength output beams 426 that cover the detection range of approximately 10 microns. In yet another non-exclusive example, the MIR laser source 420 can be controlled to sequentially generate 5 different wavelength output beams 426 that cover the detection range of approximately 5 microns. In non-exclusive examples, the set of output beams 426 can be generated over a time period of less than approximately one second.

With these designs, the detection range of the set of output beams 426 can be specifically tailored to target one or more gases 12 having strong absorption features in the detection range.

In one embodiment, the wavelength of the output beams 426 is synchronized with the MIR image so that imager control system knows the wavelength of the output beam 426 at the time each image is captured so that the gas captured in the image can be specifically identified. For example, if the gas appears in a first image captured when the output beam 428 is at a first center wavelength and the gas does not appear in a second image when the output beam 428 is at a second center wavelength, the type of gas captured in the first image can be identified if the value of the first wavelength is known.

In certain embodiments, the measurement system 456 can be calibrated during manufacturing of the laser source 420. More specifically, with the laser source 420 activated, the actuator 454 can be used to move the WD reflector 444A while monitoring position with the measurement system 456 and wavelength of the output beam 428 with the wavelength measurement device 446. With this design, each position of the measurement system 456 can be corresponded to a center wavelength of the output beam 428.

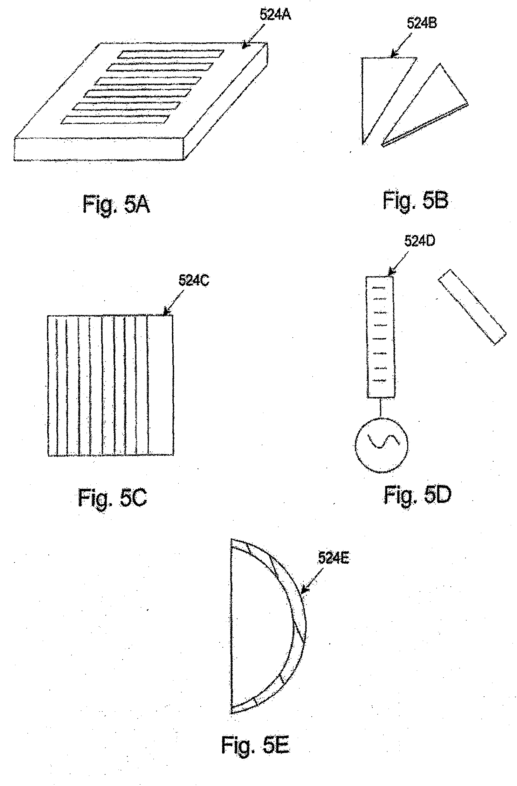

Figures 5A-5E illustrate alternative embodiments other WD feedback reflectors. More specifically, Figure 5A is a simplified illustration of a MEMS grating 524 that can be used as the WD reflector. In this embodiment, changing a voltage applied to the MEMS grating adjusts the lasing wavelength and the wavelength of the output beam (not shown in Figure 5A).

Figure 5B is a simplified side illustration of a pair of prisms 524B that can be used as the WD reflector. In this embodiment, the prisms can be moved relative to each other to adjust the lasing wavelength and the wavelength of the output beam (not shown in Figure 5B).

Figure 5C is a simplified side illustration of a thin film filter stack with a reflector 524C that can be used as the WD reflector. In this embodiment, the filter stack is designed to transmit the desired wavelength to the reflector.

Figure 5D is a simplified illustration of an acoustic optic modulator 524D that can be used as the WD reflector. In this embodiment, the RF field is changed to adjust the lasing wavelength and the wavelength of the output beam (not shown in Figure 5D).

Figure 5E is a simplified cut-way illustration of a parabolic diffraction grating 524E that can be used as the WD reflector. In this embodiment, grating 524E can be rotated to adjust the lasing wavelength. Further, in certain embodiments, with a parabolic grating 524E, the cavity optical assembly 336 (illustrated in Figure 3) may not be necessary.

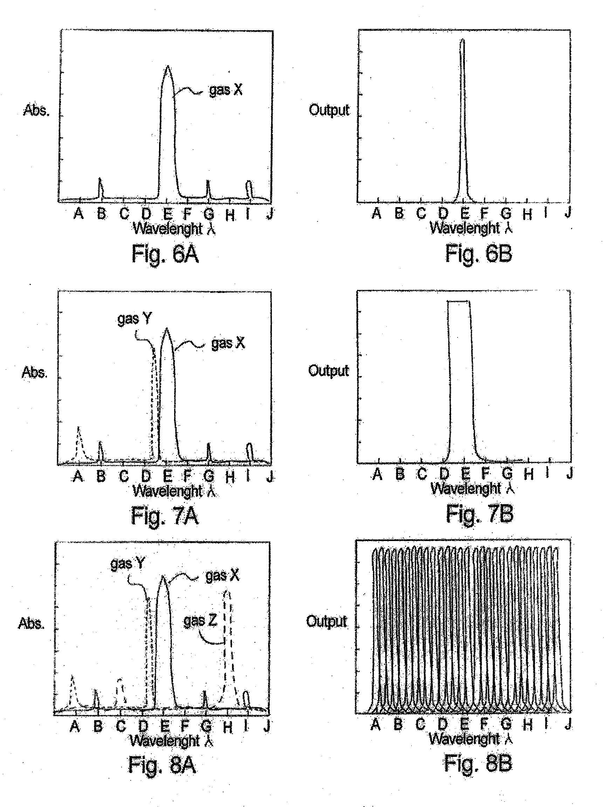

Figure 6A is a simplified graph that illustrates an absorption versus wavelength profile for a non-exclusive example of an emitting gas, that is named X in this example. It should be noted that the absorption profile illustrated in Figure 6A is merely an example that was created to facilitate this discussion and is not the absorption profile for any actual gas. In this example, the emitting gas X has significant absorption at approximately wavelength E and mild absorption at (i) approximately wavelength B, (ii) approximately wavelength G, and (iii) approximately wavelength I.

Figure 6B is a simplified graph that illustrates the wavelength of an output beam for the MIR laser source in the MIR range. More specifically, if it is desired to locate emitting gas X, the MIR laser source can be manually or electrically tuned to have a profile similar to that illustrated in Figure 6B. In this embodiment, the output beam has a center wavelength at wavelength E (at or near the peak absorption of gas X bandwidth) and a relatively narrow line width. With the present design, the MIR laser source was tuned to target the absorption features of the gas X. This enhances the accuracy of the imaging system 10.

Figure 7A is a simplified graph that illustrates the absorption versus wavelength for two emitting gas, namely gas X (illustrated as solid line) described above, and gas Y (illustrated as short dashed line) in this example. It should be noted that the absorption profiles illustrated in Figure 7A are merely an example that was created to facilitate this discussion and are not the absorption profiles for any actual gases. In this example, the emitting gas Y has significant absorption at between approximately wavelength D and E, and mild absorption at approximately wavelength A.

Figure 7B is a simplified graph that illustrates the wavelength of an output beam for the MIR laser source. More specifically, if it is desired to locate emitting gases X and Y, the MIR laser source can be manually or electrically tuned to have a profile similar to that illustrated in Figure 7B. In this embodiment, the output beam has a center wavelength that is between approximately wavelengths D and E and a relatively wide line width.

Figure 8A is a simplified graph that illustrates the absorption versus wavelength for three emitting gases, namely gas X (illustrated as solid line) described above, gas Y (illustrated as short dashed line) described above, and gas Z (illustrated as long dashed line) in this example. It should be noted that the absorption profiles illustrated in Figure 8A are merely an example that was created to facilitate this discussion and are not the absorption profiles for any actual gases. In this example, emitting gas Z has significant absorption at approximately wavelength H and mild absorption at approximately wavelength C.

Figure 8B is a simplified graph that illustrates the wavelengths of a set of output beams that can be generated by the MIR laser source. More specifically, if it is desired to locate emitting gases X, Y, and Z, the MIR laser source can be controlled to generate a set of sequential, specific, different center wavelength output beams that span a portion or the entire the MIR range. In this embodiment, after generating the set of output beams, the imager control system can analyze the images captured by the MIR imager and compare the images to a lookup table that includes the absorption profiles of the gases in interest. With this information, the imager control system can identify the gases detected and/or how much of each of the gases is present. Further, with this design, the imaging system scans for a relatively large number of gases that have absorption in the MIR range.

With this design, in certain embodiments, if a number of gases are present, a set of output beams can be generated, with corresponding images being captured by the imaging system. Subsequently, the captured images with corresponding wavelength information of the output beams can be analyzed with the imager control system using a lookup table having know absorption properties of different gases to identify which gases are present and how much gas is present.

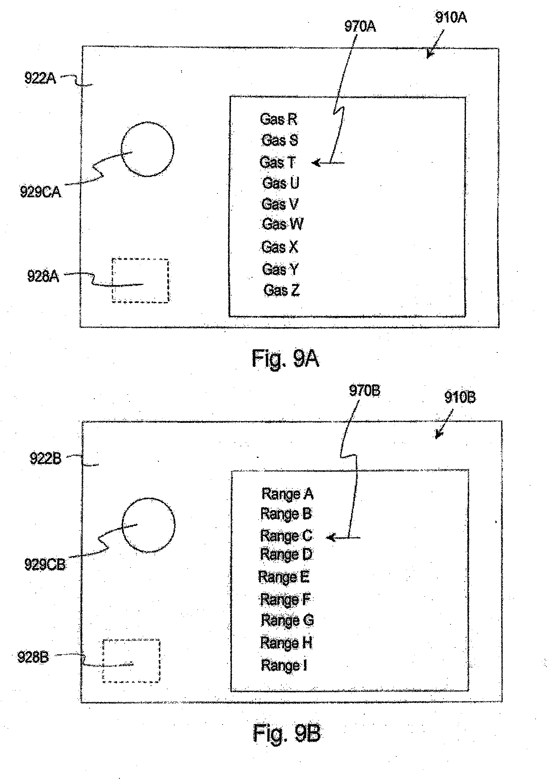

Figure 9A is a simplified illustration of a gas imaging system 91 0A including a display 922A that lists possible gases R-Z for detection and a control switch 929CA. In this example, if it is desired to search for gas T, the user of the imaging system 910A uses the control switch 929CA to move a cursor 970A to identify the gas of interest. Subsequently, the imager control system 928A controls the MIR laser source (not shown in Figure 9A) to generate an output beam (not shown in Figure 9A) having a center wavelength that corresponds to the significant absorption wavelength of gas T.

Figure 9B is a simplified illustration of another gas imaging system 910B including a display 922B that lists possible search ranges A-I and a control switch 929CB. In this example, if it is desired to search for gases having significant absorption in the search range C, the user of the imaging system 910B uses the control switch 929CB to move a cursor 970B to identify the search range. Subsequently, the imager control system 928B controls the MIR laser source (not shown in Figure 9B) to generate a set of output beams (not shown in Figure 9B) that encompass the search range C.

Figure 10 illustrates a simplified side illustration of yet another embodiment of a gas imaging system 1010 that is suited for imaging, locating, identifying, and/or detecting an emitting gas 12 from a gas source 14. In this embodiment, the imaging system 1010 includes a MIR imager 1016 and a MIR laser source 1020 that are somewhat similar to the corresponding components described above and illustrated in Figure 1. However, in this embodiment, the MIR laser source 1020 includes a plurality of laser sources 1021 that each generates an output beam 1026 that is in the MIR range. In Figure 10, the MIR laser source 1020 is illustrated as having three individual laser sources 1021. Alternatively, MIR laser source 1020 can have more than three or fewer than three laser sources 1021. With this design, the MIR laser source 1020 can generate a set of concurrent or sequential, output beams 1026 with each having a different center wavelength that span a portion or the entire the MIR range.

Additionally, in Figure 10, the plurality of laser sources 1021 are fixedly secured together with the MIR imager 1016. Alternatively, one or more of the laser sources 1021 can be spaced apart and movable relative to the other laser sources 1021 or the MIR imager 1016.

In this embodiment, one or more of the laser sources 1021 can be designed somewhat similar to the laser source 320 illustrated in Figure 3 or the laser source 420 illustrated in Figure 4 and described above.

Figure 11 is a graph that illustrates power directed to a QC gain media 334 (illustrated in Figure 3) versus time. Referring to both Figures 3 and 11, in one embodiment, the laser electronic controller 340 pulses the power (as opposed to constant power) directed to the QC gain media 334 in a low duty cycle wave form. In one non-exclusive example, the laser electronic controller 340 directs approximately 5-20 watts peak for a relatively short period of time (e.g. 100-200 nanoseconds), and the laser electronic controller 340 directs low or no power to the QC gain media 334 between the peaks. With this design, relatively high power is directed to the QC gain media 334 for short, spaced apart periods of time. As a result thereof, the QC gain media 334 lases with little to no heating of the core of the QC gain media 334, the average power directed to the QC gain media 334 is relatively low, and the desired average optical power of the output beam 326 can be efficiently achieved. It should be noted that as the temperature of the QC gain media 334 increases, the efficiency of the QC gain media 334 decreases. With this embodiment, the pulsing of the QC gain media 334 keeps the QC gain media a 334 operating efficiently and the overall system utilizes relatively low power. As a result thereof, the laser source 320 can be battery powered. A suitable duty cycle and circuit capable of directing pulsed power to the QC gain media 334 is described in U.S. Provisional Patent Application No. 60/934,952 filed on March 12, 2007, and entitled BATTERY POWERED HIGHLY MOBILE MID-IR LASER SYSTEMS, the contents of which are incorporated herein by reference.

It should be noted that the pulsed power to the QC gain media 334 can be used in concert with the MIR imager 16 (illustrated in Figure 1) to enable signal processing techniques to improve image quality.

While the particular imaging systems as shown and disclosed herein is fully capable of obtaining the objects and providing the advantages herein before stated, it is to be understood that it is merely illustrative of the presently preferred embodiments of the invention and that no limitations are intended to the details of construction or design herein shown other than as described in the appended claims.

## Claims

1. An imaging system for imaging an emitting gas, the imaging system comprising:
an imager adapted to capture an image of light in the mid-infrared (MIR) range; and
a laser source including a semiconductor laser that is adapted emit an output beam in the MIR range, the output beam being adapted to be absorbed by the emitting gas.

2. The imaging system of claim 1, wherein the laser source includes a QC gain media.

3. The imaging system of claim 2, wherein the laser source includes an external cavity.

4. The imaging system of claim 3, wherein the laser source includes a mounting base that fixedly retains the QC gain media, a cavity optical assembly that is fixedly secured to the mounting base spaced apart from the QC gain media, and a wavelength dependent (WD) reflector secured to the mounting base spaced apart from the QC gain media; the WD reflector cooperating with the QC gain media to form the external cavity that lases within the MIR range.

5. The imaging system of claim 4, wherein the WD reflector includes a diffraction grating, and wherein the imaging system further comprises a battery adapted to power the laser source.

6. The imaging system of claim 1 wherein the laser source sequentially generates a plurality of output beams having different center wavelengths that are within the MIR range.

7. The imaging system of claim 1, wherein the laser source generates a plurality of output beams having different center wavelengths that are within the MIR range.

8. The imaging system of claim 1, wherein the laser source generates a plurality of output beams having different center wavelengths that are within the MIR range at approximately the same time.

9. The imaging system of claim 1, further comprising:
a temperature controller adapted to control the temperature of at least a portion of the laser source.

10. The imaging system of any of the claims 1 to 5 and 9, wherein:
the laser source is adapted to generate the output beam having a first center wavelength and a second output beam having a second center wavelength within the MIR range, the second center wavelength being different than the first center wavelength.

11. A method for imaging an emitting gas, comprising:
capturing an image of light in the mid-infrared (MIR) range with an imager; and
emitting an output beam in the MIR range with a laser source that includes a semiconductor laser adapted to directly emit the output beam, the output beam being backscattered near the emitting gas.

12. The method of claim 11, wherein the emitting an output beam includes selectively adjusting a wavelength of the output beam within the MIR range.

13. The method of claim 11, wherein the emitting an output beam includes emitting a plurality of output beams having different center wavelengths that are within the MIR range.

14. The method of claim 11, further comprising:
analyzing the captured image to estimate how much of the emitting gas is present.

15. The method of claim 11, further comprising:
analyzing the captured image to identify the emitting gas.
